# EUROPÄISCHE PATENTSCHRIFT

(11) **EP 1 658 641 B1**
(45) Veröffentlichungstag und Bekanntmachung des Hinweises auf die Patenterteilung: **11.11.2009**
(21) Anmeldenummer: 04762681.7
(22) Anmeldetag: 16.08.2004
(51) Int. Cl.: H01L 29/786, H01L 21/336

(54) **VERFAHREN ZUR HERSTELLUNG VERTIKALER NANO-TRANSISTOREN**
METHOD FOR PRODUCING VERTICAL NANOTRANSISTORS
PROCEDE DE PRODUCTION DE NANOTRANSISTORS VERTICALS

(30) Priorität: 21.08.2003 DE 10339531
(43) Veröffentlichungstag der Anmeldung: 24.05.2006
(73) Patentinhaber: Helmholtz-Zentrum Berlin für Materialien und Energie GmbH, 14109 Berlin (DE)
(72) Erfinder: CHEN, Jie, 10589 Berlin (DE); LUX-STEINER, Martha, Christina, 14163 Berlin (DE)
(74) Vertreter: Rudolph, Margit
(86) Internationale Anmeldenummer: PCT/DE2004/001838
(87) Internationale Veröffentlichungsnummer: WO 2005/022646

(56) Entgegenhaltungen:
- WO-A-2004/040666
- DE-A- 10 142 913
- US-A- 5 612 563
- US-B1- 6 426 259
- MAEDA S ET AL: "A VERTICAL -SHAPE TRANSISTOR (V T) CELL FOR 1GBIT DRAM AND BEYOND" SYMPOSIUM ON VLSI TECHNOLOGY. DIGEST OF TECHNICAL PAPERS. HONOLULU, JUNE 7 - 9, 1994, NEW YORK, IEEE, US, Bd. SYMP. 14, 7. Juni 1994 (1994-06-07), Seiten 133-134, XP000498617 ISBN: 0-7803-1922-2

## Beschreibung

Die Erfindung betrifft einen vertikalen Nano-Transistor, aufweisend Source-, Drain-, Gate-Bereich und einen halbleitenden Kanalbereich zwischen Source- und Drain-Bereich, wobei der Gate-Bereich und der halbleitende Kanalbereich eine koaxiale Struktur bilden und der Source-Bereich, der halbleitende Kanalbereich und der Drain-Bereich in vertikaler Richtung angeordnet sind, sowie ein Verfahren zu seiner Herstellung..

In der DE-OS 101 42 913 ist eine mechanischen Beanspruchungen durch Biegung, Scherung oder Dehnung gut widerstehende Transistoranordnung beschrieben, bei der in Mikrolöchern eines Folienverbundes, der aus zwei Kunststofffolien mit zwischenliegender Metallschicht besteht, vertikal Halbleitermaterial eingebracht ist. Das Halbleitermaterial ist mit metallischen Kontakten auf der Ober- und Unterseite des Folienverbundes versehen. Der Gate-Bereich erstreckt sich in dieser Transistoranordnung nur über einen geringen Teil der Tiefe der Mikrolöcher und ist in ihrer Mitte angeordnet. Bei dieser Anordnung ist jedoch das Aufbringen einer Metallschicht auf eine Kunststofffolie nicht einfach handhabbar; außerdem umfasst das Verfahren zur Herstellung einer solchen vertikalen Transistoranordnung eine Vielzahl von einzelnen Verfahrensschritten.

Auch der in US 2002/0001905 beschriebene vertikale Nano-Transistor ist in seiner Herstellung aufwändig und kompliziert, da zunächst auf einem teuren Halbleiter-Substrat, das nicht flexibel ist, ein Source-Bereich und darauf eine isolierende Schicht aufgebracht wird. In der isolierenden Schicht (Al₂O₃ oder Si) sind Löcher im nm-Bereich angeordnet und in diesen Löchern sind vertikal ausgerichtete Kohlenstoff-Nanoröhren eingebracht. Der Gate-Bereich ist über der isolierenden Schicht um die Kohlenstoff-Nanoröhren angeordnet, dieser ist bis auf die obere Deckfläche der Nanoröhren ausgefüllt mit einem nichtleitenden Material. Das Ausbilden des Gate-Bereichs um die Nanoröhren und das Erhalten dieser Nanoröhren mit gleichen Durchmessern während des Auffüllens erweist sich als sehr schwierig. Dies kann zur Folge haben, dass vertikale Transistor-Anordnungen entstehen, die wegen der unterschiedlichen Durchmesser der jeweils zugehörigen Nanoröhre auch unterschiedliche Charakteristiken aufweisen.

Auch in US 6,426,259 B1 und US 5,612,563 B1 werden Lösungen beschrieben, bei- denen die vertikale Transistoranordnung ausgehend von einem Halbleitersubstrat aufgebaut wird. Das Substrat behindert aber auch hier die Ausbildung einer flexiblen Transistoranordnung und macht für die Funktionsweise der dort beschriebenen Anordnungen die Ausbildung von technischen Mitteln im Substrat - wie beispielsweise Drain-Bereich, zusätzliche lsolationsbereiche - erforderlich.

Aufgabe der Erfindung ist es deshalb, eine Herstellungsvefahren für einen vertikalen Nano-Transistor anzugeben, der mechanischen Beanspruchungen gut widersteht und in seiner Herstellung weniger aufwändig ist, als bisher dem Stand der Technik nach bekannt.

Die Aufgabe wird für einen vertikalen Nano-Transistor der eingangsgenannten Art dadurch gelöst, dass erfindungsgemäß der Gate-Bereich durch eine Metallfolie einer Dicke von weniger als 100 µm, vorzugsweise 5 bis 20 µm, gebildet ist und der Gate-Bereich eine elektrische Isolierung zum Source-Bereich, zum Drain-Bereich und zum halbleitenden Kanalbereich aufweist.

In der erfindungsgemäßen Lösung bildet eine extrem dünne Metallfolie den Gate-Bereich. Es entfällt das schwierige Aufbringen einer Metallschicht auf eine Kunststofffolie; außerdem müssen die einzelnen Folien nicht wie in der erwähnten Lösung zu einem Folienverbund zusammengefügt werden. Die Dichte der für die zu bildende koaxiale Struktur in die Metallfolie eingebrachten Löcher ist sehr hoch.

In Ausführungsformen der Erfindung ist vorgesehen, den halbleitenden Kanalbereich zylinderförmig auszubilden. Der Durchmesser des halbleitenden Kanalbereiches beträgt einige Zehn bis einige Hundert Nanometer. Das Material des halbleitenden Kanalbereiches ist CuSCN oder TiO₂ oder PbS oder ZnO oder ein anderer Verbindungshalbleiter.

Die. Metallfolie ist im Vergleich zur Kunststofffolie gleichmäßiger in ihrer Höhe, wodurch bei der geringen Dicke gewährleistet ist, dass die eingebrachten Löcher auch wirklich durch die Folie durchgehen. Außerdem ist die erfindungsgemäße Anordnung durch die sehr dünne Metallfolie sehr widerstandsfähig gegenüber mechanischen Beanspruchungen.

Eine andere Ausführungsform sieht vor, dass die Dicke der elektrischen Isolierung in dem Kanalbereich einige bis einige Hundert Nanometer beträgt. Die Dicke der Isolationsschicht auf der Ober- und Unterseite der Metallfolie beträgt einige Mikrometer.

Als Material für den Source- und den Drain-Bereich ist Au oder Ag oder Cu oder Ni oder Al vorgesehen. Der Source- und Drain-Bereich kann punktförmig ausgebildet sein.

Eine mögliche Speicheranordnung weist eine Vielzahl nebeneinander in einer Metallfolie angeordneter vertikaler Nano-Transistoren mit den beschriebenen Merkmalen auf.

Das erfindungsgemäße Verfahren zur Herstellung vertikaler Nano-Transistoren gemäß Anspruch 1, umfasst mindestens die Verfahrensschritte: Erzeugen von Löchern in einer den Gate-Bereich des Transistors bildenden dünnen Metallfolie zur Ausbildung des Kanalbereiches, Aufbringen von Isolatormaterial an die Wandung der Löcher und auf der Ober- und Unterseite der Metallfolie mittels Vakuumfiltration einer Polymerlösung, Einbringen von halbleitendem Material in die isolierten Löcher zur Bildung des halbleitenden Kanalbereiches, Aufbringen von Kontakten zur Ausbildung des Source- und Drain-Bereiches.

In Ausführungsformen zum erfindungsgemäßen Verfahren ist vorgesehen, die Löcher in der Metallfolie mittels fokussierter lonenstrahlen oder mittels Laserstrahl zu erzeugen.

Das Isolatormaterial wird mittels Vakuumfiltration einer Polymerlösung auf die Wandung der Löcher und auf Ober- und Unterseite der Metallfolie aufgebracht.

In anderen Ausführungsformen der Erfindung ist vorgesehen, das Halbleitermaterial, wobei CuSCN oder TiO₂ oder PbS oder ZnO oder ein anderer Verbindungshalbleiter verwendet werden kann, mittels elektrochemischer Badabscheidung oder chemischer Deposition oder mittels ILGAR-Verfahren in die isolierten Löcher der Metallfolie einzubringen.

Das Herstellungsverfahren für die erfindungsgemäße vertikale Nano-Transistor-Anordnung ist einfach und passt sich in die bekannten Dünnfilmtechologien ein. Aufgrund der erfindungsgemäßen Anordnung ist eine Begrenzung auf bestimmte Temperaturen im Herstellungsverfahren nicht mehr notwendig.

Diese Zeichnung zeigt die Herstellungsschritte vertikaler Nano-Transistoren, die in eine Metallfolie eingebettet sind.

Zunächst werden in eine Metallfolie 1, beispielsweise eine 30 µm dicke Al- oder Cu-Folie, mittels Laserbestrahlung Löcher 4 mit einem Durchmesser von 200 nm eingebracht. Anschließend wird eine Isolationsschicht 2 aus organischem Material, z.B. Polystyrene durch Vakuumfiltration einer Polymerlösung, auf die Wandung der Löcher 4 aufgebracht. Die Dicke dieser Schicht 2 beträgt 50 nm. Mittels bekannter Dünnschichttechniken wird anschließen auch auf der Ober- und Unterseite der Metallfolie 1 eine Isolationsschicht 2 mit einer Dicke von einigen Mikrometern aufgebracht. Danach werden die isolierten Löcher 4 in der Metallfolie 1 mit CuSCN verfüllt. Damit ist die Bildung eines halbleitenden Kanalbereiches 3 mit einem Durchmesser von 100 nm abgeschlossen. Abschließend werden metallische Kontakte als Drain- D und Source-Kontakte S aufgebracht.

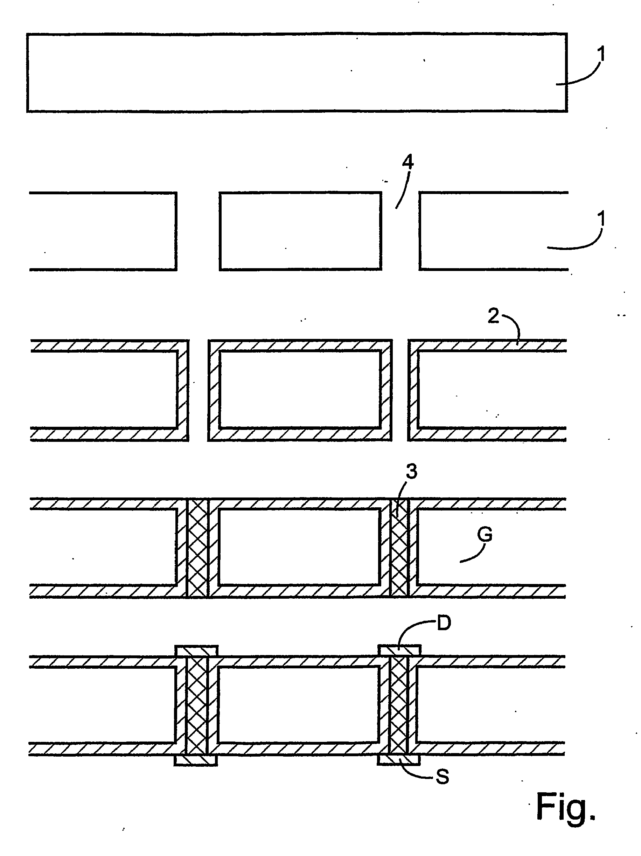

## Patentansprüche

1. Verfahren zur Herstellung vertikaler Nano-Transistoren, umfassend mindestens die Verfahrensschritte
- Erzeugen von Löchern (4) in einer den Gate-Bereich (G) des Transistors bildenden dünnen Metallfolie (1) zur Ausbildung des Kanalbereiches (3),
- Aufbringen von Isolatormaterial (2) an die Wandung der Löcher (4) und auf die Ober- und Unterseite der Metallfolie (1) mittels Vakuumfiltration einer Polymerlösung,
- Einbringen von halbleitendem Material in die isolierten Löcher (4) zur Bildung des halbleitenden Kanalbereiches (3),
- Aufbringen von Kontakten zur Ausbildung des Source- (S) und Drain-Bereiches (D).

2. Verfahren nach Anspruch 1,
bei dem die Löcher (4) in der Metallfolie (1) mittels fokussierter lonenstrahlen erzeugt werden.

3. Verfahren nach Anspruch 1,
bei dem die Löcher (4) in der Metallfolie (1) mittels Laserstrahl erzeugt werden.

4. Verfahren nach Anspruch 1,
bei dem das Isolatormaterial mittels Dünnfilmtechnologie auf die Ober- und Unterseite der Metallfolie (1) aufgebracht wird.

5. Verfahren nach Anspruch 1,
bei dem das Isolatormaterial mittels elektrochemischer Deposition auf die Wandung der Löcher (4) und auf Ober- und Unterseite der Metallfolie (1) aufgebracht wird.

6. Verfahren nach Anspruch 1,
bei dem das Isolatormaterial mittels chemischer Deposition auf die Wandung der Löcher (4) und auf Ober- und Unterseite der Metallfolie (1) aufgebracht wird.

7. Verfahren nach Anspruch 1,
bei dem als Material für den halbleitenden Kanalbereich (3) CuSCN oder TiO₂ oder PbS oder ZnO oder ein anderer Verbindungshalbleiter verwendet wird.

8. Verfahren nach Anspruch 1,
bei dem das Halbleitermaterial durch elektrochemische Badabscheidung in die isolierten Löcher (4) eingebracht wird.

9. Verfahren nach Anspruch 1,
bei dem das Halbleitermaterial durch chemische Deposition in die isolierten Löcher (4) eingebracht wird.

10. Verfahren nach Anspruch 1,
bei dem das Halbleitermaterial durch das ILGAR-Verfahren in die isolierten Löcher (4) eingebracht wird.

11. Verfahren nach Anspruch 1,
bei dem als Material für den Source- und den Drain-Bereich Au oder Ag oder Cu oder Ni oder Al verwendet wird.

## Claims

1. A method for producing vertical nanotransistors, said method comprising at least the steps of
- creating holes (4) in a thin metal foil (1) forming the gate region (G) of the transistor to form the channel region (3);
- applying insulator material (2) to the wall of the holes (4) and to the upper surface and lower surface of the metal foil (1) by means of vacuum filtration of a polymer solution;
- placing semiconducting material into the insulated holes (4) to form the semiconducting channel region (3);
- applying contacts to form the source region (S) and drain region (D).

2. A method according to claim 1
wherein the holes (4) in the metal foil (1) are created by means of focused ion beams.

3. A method according to claim 1
wherein the holes (4) in the metal foil (1) are created by means of a laser beam.

4. A method according to claim 1
wherein the insulator material is applied to the upper surface and lower surface of the metal foil (1) by means of thin film technology.

5. A method according to claim 1
wherein the insulator material is applied to the wall of the holes (4) and to the upper surface and lower surface of the metal foil (1) by means of electrochemical deposition.

6. A method according to claim 1
wherein the insulator material is applied to the wall of the holes (4) and to the upper surface and lower surface of the metal foil (1) by means of chemical deposition.

7. A method according to claim 1
wherein CuSCN or TiO₂ or PbS or ZnO or another compound semiconductor is used as material for the semiconducting channel region (3).

8. A method according to claim 1
wherein the semiconductor material is placed into the insulated holes (4) by electrochemical bath deposition.

9. A method according to claim 1
wherein the semiconductor material is placed into the insulated holes (4) by chemical deposition.

10. A method according to claim 1
wherein the semiconductor material is placed into the insulated holes (4) by the ILGAR method.

11. A method according to claim 1
wherein Au or Ag or Cu or Ni or Al is used as material for the source region and the drain region.

## Revendications

1. Procédé pour fabriquer des nano-transistors verticaux, comprenant au moins les étapes de procédé suivantes :
- génération de trous (4) dans une feuille de métal (1) mince formant la zone de grille (G) du transistor pour la formation de la zone de canal (3),
- application de matériau isolant (2) sur la paroi des trous (4) et sur le côté supérieur et le côté inférieur de la feuille de métal (1) au moyen de filtration par vide d'une solution polymère,
- introduction de matériau semi-conducteur dans les trous (4) isolés pour former la zone de canal (3) semi-conductrice,
- application de contacts pour former la zone source (S) et la zone drain (D).

2. Procédé selon la revendication 1,
avec lequel les trous (4) dans la feuille de métal (1) sont générés au moyen de faisceaux d'ions focalisés.

3. Procédé selon la revendication 1,
avec lequel les trous (4) dans la feuille de métal (1) sont générés au moyen d'un faisceau laser.

4. Procédé selon la revendication 1,
avec lequel le matériau isolant est appliqué par la technologie de film mince sur le côté supérieur et le côté inférieur de la feuille de métal (1).

5. Procédé selon la revendication 1,
avec lequel le matériau isolant est appliqué par déposition électrochimique sur la paroi des trous (4) et sur le côté supérieur et le côté inférieur de la feuille de métal (1).

6. Procédé selon la revendication 1,
avec lequel le matériau isolant est appliqué par déposition chimique sur la paroi des trous (4) et sur le côté supérieur et le côté inférieur de la feuille de métal (1).

7. Procédé selon la revendication 1,
avec lequel du CuSCN ou TIO₂ ou PbS ou ZnO ou un autre semi-conducteur de liaison est utilisé comme matériau pour la zone de canal (3) semi-conductrice.

8. Procédé selon la revendication 1,
avec lequel le matériau semi-conducteur est introduit dans les trous (4) isolés par précipitation de bain électrochimique.

9. Procédé selon la revendication 1,
avec lequel le matériau semi-conducteur est introduit dans les trous (4) isolés par déposition chimique.

10. Procédé selon la revendication 1,
avec lequel le matériau semi-conducteur est introduit dans les trous (4) isolés par le procédé ILGAR.

11. Procédé selon la revendication 1,
avec lequel du Au ou Ag ou Cu ou Ni ou Al est utilisé comme matériau pour la zone source et la zone drain.
